# EUROPÄISCHE PATENTSCHRIFT

(11) **EP 4 078 668 B1**
(45) Veröffentlichungstag und Bekanntmachung des Hinweises auf die Patenterteilung: **10.01.2024**
(21) Anmeldenummer: 19835284.1
(22) Anmeldetag: 19.12.2019
(51) Int. Cl.: H01L 23/08, H01L 21/56, H01L 23/06, H01L 33/44, H01L 21/67, H01L 23/10, H10K 50/842, H10K 71/00, H01L 33/00

(54) **VEREINZELTES VERKAPSELTES BAUELEMENT UND VERFAHREN ZU DESSEN HERSTELLUNG**
SINGULATED ENCAPSULATED COMPONENT AND METHOD FOR THE MANUFACTURING THEREOF
COMPOSANT ISOLÉ ENCAPSULÉ ET SON PROCÉDÉ DE FABRICATION

(43) Veröffentlichungstag der Anmeldung: 26.10.2022
(73) Patentinhaber: EV Group E. Thallner GmbH, 4782 St. Florian am Inn (AT)
(72) Erfinder: MITTENDORFER, Gerald, 4975 Stuben (AT); LINDNER, Paul Friedrich, 4780 Schärding (AT)
(74) Vertreter: Schneider, Sascha
(86) Internationale Anmeldenummer: PCT/EP2019/086421
(87) Internationale Veröffentlichungsnummer: WO 2021/121608

(56) Entgegenhaltungen:
- WO-A1-2017/203795
- US-A1- 2004 038 442
- US-A1- 2005 059 188
- US-A1- 2007 021 524
- US-A1- 2010 243 999
- US-A1- 2015 266 772

## Beschreibung

Die Erfindung betrifft ein Verfahren und Bauelemente gemäß den nebengeordneten Ansprüchen.

Die Fertigung von Bauelementen in der Halbleiterindustrie wird in die Bereiche Scheibenfertigung (engl.: frontend) und Montage (engl.: backend) unterteilt. Je nach Fläche der Bauelemente enthält ein Substrat bzw. ein Wafer nach der Scheibenfertigung bis zu mehrere hundert Bauelemente. Durch Sägen (engl.: dicing) werden die Bauelemente vereinzelt und in der Montage verdrahtet und verkapselt oder in Gehäuse eingegossen. Es können auch eine Vielzahl von Bauelementen auf einen gemeinsamen Träger montiert werden und danach erfolgt die Verkapselung (engl.: packaging).

Gießharze oder Vergussmassen wie z.B. Epoxidharze, die zum Eingießen von Bauelementen verwendet werden, sind nicht die bevorzugte Ausführung einer hermetischen Verkapselung. Diese Vergussmassen eignen sich insbesondere für Halbleiterbauelemente die keinen Gehäusehohlraum benötigen. Sobald optische oder mechanische Eigenschaften der Bauelemente beeinträchtigt werden, können Vergussmassen nicht mehr eingesetzt werden.

Die Verkapselung in einem Gehäuse dient sowohl dem mechanischen Schutz als auch der Abschirmung vor Umwelteinflüssen wie Luftfeuchtigkeit, Sauerstoff oder Staubpartikel. Eine hermetische Verpackung ermöglicht es, im Gehäuse eine luftdichte Atmosphäre aufzubauen und somit die Bauelemente je nach Bedarf in Vakuum oder unter Schutzgasatmosphäre zu lagern. Oft wird z.B. der Bauelement-Träger mit dem Gehäusedeckel unter Schutzgas verklebt oder verlötet. Um ein Vakuum in den Verkapselungen länger zu ermöglichen, kann auch ein Getter eingesetzt werden. Der Getter ist ein chemisch reaktives Material, welches Moleküle durch eine chemische Reaktion oder durch Sorption binden kann.

Die Bauelemente bzw. Baueinheiten sind Funktionseinheiten insbesondere optischer und/oder elektronischer Art, z.B. unter anderem Sensoren, Chips, LEDs (Leuchtdioden) bzw. optoelektronische Bauelemente, MEMS (mikroelektromechanische Systeme), Linsen sowie Linsenstapel, Resonatoren, usw. Zu den Sensoren die Verkapselt werden gehören z.B. optische Sensoren, Beschleunigungssensoren und Drehsensoren. Ein Bauelement bzw. eine Baueinheit kann eine integrierte Schaltung enthalten, die bei der Bearbeitung des Halbleitersubstrats entsteht.

MEMS werden im Stand der Technik oft einzeln in Packages hermetisch dicht verpackt. Die Einzelchipverarbeitung ist aber aufwendig.

In den letzten Jahren wurden deshalb neue Packagingkonzepte entwickelt die, insbesondere nach der Waferstrukturierung, den Verkapselungsprozeß vollständig auf Waferebene durchführen. Wafel Level Packaging (WLP) vermeidet die Handhabung von einzelnen Bauelementen durch eine Verkapselung auf Waferebene. Das WLP unterscheidet sich somit vom konventionellen Verkapseln dadurch, dass alle Prozesse direkt auf dem Substrat bzw. Wafer erfolgen und erst nach dem Verkapseln die WLP-Packages aus dem Wafer durch Sägen oder andere Methoden wie Laserbestrahlung vereinzelt werden. Der Formfaktor, der die Größe eines Bauteils definiert, und der sich aus dem Verhältnis von Verkapselungsgröße zu Bauelementgröße berechnet, ist daher nahezu gleich 1.

Werden mehrere Bauelemente, insbesondere Chips, auch vertikal in zwei oder mehr schichten integriert, spricht man von einem 3D-integrierten Schaltkreis (3D-IC). Das Verkapseln von 3D-ICs, 3D-Packaging, spart Platz durch das Stapeln mehrerer Chips in einem einzigen Gehäuse. In einem Wafer-to-Wafer (W2W) Verfahren wird der Wafer und die darauf befindlichen Bauelemente mit dem Deckelsubstrat verbunden und dann zersägt. Alternativ wäre auch ein Chip-to-Wafer (C2W) Verfahren möglich, wo beispielsweise bereits vereinzelte Deckel einzeln auf die abgegrenzten Bauelemente aufgebracht werden. Danach wird der Wafer mit den fertigen verkapselten Bauelementen zersägt. C2W Verfahren ermöglichen die Verwendung von Chips unterschiedlicher Größen.

Durch die Anforderungen der Miniaturisierung kommen konventionelle Gehäuse aus Keramik oder Metall, die beispielsweise aus einer Wanne und einem Deckel bestehen und miteinander verklebt, verschweißt oder verlötet werden, nicht mehr in Frage.

Im Stand der Technik existieren viele Ansätze für nahezu-hermetische oder hermetische Verkapselungen auf Waferebene, beispielsweise Verfahren die u.a. ein verschweißen oder verlöten mit Metallen beinhalten, Bondverfahren wie z.B. Glas-Frit-Bonden, Fusionsbonden, anodisches Bonden oder adhäsives Bonden mit Klebstoffe, oder die Verwendung von Polymer-Materialien wie Benzocyclobutene (BCBs) oder Flüssigkristalline Polymere (LCPs).

Beim anodischen Bonden werden dreidimensional-strukturierte Glaswafer zum Verkapseln von Bauelemente auf einem Substrat bzw. Produktwafer verwendet. Analog werden bei anderen Bondverfahren strukturierte Siliziumwafer benötigt. Das Deckeln mit einem 3-D strukturierten Deckelsubstrat ist aber aufwendig und kostenintensiv, da die 3-D Strukturen zuerst hergestellt werden müssen. Ein weiteres Problem sind hohe Prozesstemperaturen, die eine Anwendung von Verfahren wie Fusionsbonden limitieren.

Für eine nahezu hermetische Versiegelung werden im Stand der Technik BCBs als Zwischenschichten verwendet. Diese polymerisieren unter Wärmeeinwirkung und werden in der Halbleiterindustrie als Dielektrika, Zwischenschichten oder Versiegelungsschichten eingesetzt. LCPs besitzen gute Barriereeigenschaften gegen Gase und Wasserdampf, was im Einsatz als Folien für die Verkapselung von Bauelemente ausgenutzt wird. Die LCP-Folie überdeckt z.B. ein Produktsubstrat und beinhaltet Kavitäten für die einzelnen Bauelemente. BCBs und LCPs ermöglichen aber nur eine nahezu hermetische Verkapselung.

Werden Klebstoffe eingesetzt, erfolgt die Verkapselung mit Hilfe von Deckelsubstraten, die unter Verwendung eines Klebstoffes mit den mit Bauelementen bestückten Substrat bzw. Produktsubstrat verbunden werden. Sind die Klebstoffe Polymere, sollten die Barriereeigenschaften der Polymere auch für eine hermetische Abdichtung geeignet sein.

Die Herstellung von hermetischen Verkapselungen im Sinne von Diffusions-Dichtheit der hergestellten Verkapselungen ist noch immer eine Herausforderung, speziell wenn ein Gehäusehohlraum vorhanden ist. Eine hermetische Verpackung ermöglicht es, im Gehäuse eine luftdichte Atmosphäre aufzubauen und somit die Bauelemente je nach Bedarf in Vakuum oder unter Schutzgasatmosphäre zu lagern. Ist eine Hermetizität nicht oder nur unzureichend gegeben, wird die Beständigkeit oder Lebensdauer der Bauelemente verkürzt. Oftmals verursacht eine mit der Zeit eindringende Feuchtigkeit Probleme wie Störungen durch Kondensationsbildung oder Korrosionsbildung. Organische Leuchtdioden sind z.B. nicht nur gegen Feuchtigkeit sondern auch gegen Sauerstoff sehr empfindlich.

Das Problem mit den Klebern im heutigen Stand der Technik ist, dass oft nicht hermetische oder nur nahezu hermetische Verkapselungen erreicht werden. Mit Epoxy-Kleber ist eine hermetische Verkapselung z.B. nicht möglich.

Weiter wird nicht nur ein Kleber benötigt, sondern eine die einzelnen Bauelementen umschließende Rahmenstruktur muss vorher aufgetragen oder aufgebaut werden. Das kann am Produktsubstrat und/oder am Deckelsubstrat sein und/oder es kann auch eine strukturierte Substrat-Abdeckung i.e. Deckelsubstrat sein.

Die EP1474356B1 verwendet eine Rahmenstruktur aus photostrukturierbarem Epoxidharz wie z.B. SU-8. Die Verbindung von Deckelsubstrat mit der Rahmenstruktur erfolgt entweder mit Hilfe einer zusätzlichen Klebeschicht oder durch Bonden vom Deckelsubstrat mit der Rahmenstruktur.

In US6,995,462B2 wird ein durchsichtiges Deckelsubstrat auf einen Produktwafer mit optischen Sensoren gebondet. Dabei wird der Kleber strukturiert direkt auf dem Produktwafer oder auf dem Deckelsubstrat aufgetragen. Der verwendete Kleber ist z.B. ein Epoxy-, Silikon- oder AcrylKleber. Danach werden die verkapselten Bauelemente vereinzelt.

Auch die US7,541,658B2 zeigt ein mehrmaliges Auftragen von vernetzbarem Material um die einzelnen Chip-Sensoren eines Trägersubstrats, um eine Rahmenstruktur aufzubauen. Danach werden die Chips mit einem Deckelsubstrat verkapselt.

Nachteilig muss im Stand der Technik die Rahmenstruktur mit einer Klebeschicht am Trägersubstrat und mit einer weiteren Klebeschicht am Deckelsubstrat befestigt werden. Dieses Verfahren umfasst sehr viele Schritte und ist sehr aufwendig.

Das Problem mit dem Stand der Technik besteht weiterhin darin, dass mit konventionellen Klebern oder weiteren Materialien, die für die Rahmenstruktur verwendet werden, nach der Vereinzelung der verkapselten Bauelemente, oft nur eine ungenügend hermetische Versiegelung der Verpackung erreicht werden kann. Das bedeutet Probleme mit der Langzeit-Zuverlässigkeit und eine verkürzte Lebensdauer der verkapselten Bauelemente.

Die zu lösende Aufgabe dieser Erfindung besteht darin, die Nachteile des Stands der Technik zu beseitigen und insbesondere darin, ein verbessertes und vereinfachtes Verfahren zur hermetischen Verkapselung eines Bauelements anzugeben.

Diese Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Erfindung betrifft ein Verfahren zur Herstellung von vereinzelten verkapselten Bauelementen, mit den folgenden Schritten:
- Aufbringen einer Rahmenstruktur auf eine Substratoberfläche eines Substrats, wobei die Rahmenstruktur auf der Substratoberfläche angeordnete Baueinheiten umschließt,
- Bonden eines Deckelsubstrats auf die Rahmenstruktur,
- Aushärtung der Rahmenstruktur,
- Vereinzelung der verkapselten Bauelemente,

wobei die Rahmenstruktur erfindungsgemäß aus einem Kleber gebildet wird,
wobei die vereinzelten verkapselten Bauelemente mit Plasma und/oder reaktivem Gas behandelt werden, wobei durch die Plasma- und/oder Gasbehandlung eine chemische Umwandlung der äußeren Oberfläche der Rahmenstruktur erfolgt.

Die Erfindung betrifft weiterhin ein vereinzeltes verkapseltes Bauelement, hergestellt mit einem erfindungsgemäßen Verfahren.

Vorteilhaft ist ein schnelleres und einfacheres herstellen der Rahmenstruktur möglich und zugleich ist eine zusätzliche Klebeschicht nicht erforderlich, sodass weniger Arbeitsschritte notwendig sind.

Der Erfindung liegt insbesondere der Gedanke zugrunde, dass nach der Vereinzelung der Bauelemente eine Nachbehandlung der Rahmenstruktur erfolgt, um eine gänzlich hermetische Verkapselung zu erreichen im Sinne von Diffusions-Dichtheit.

Bevorzugt ist der Kleber ein Silikonkleber. Hierdurch ist vorteilhaft eine verbesserte Dichtigkeit erreichbar.

Bevorzugt werden die vereinzelten verkapselten Bauelemente derart behandelt, dass eine glasartige Struktur entsteht, insbesondere eine SiO2-Struktur. Hierdurch ist vorteilhaft eine verbesserte Dichtigkeit erreichbar. Bevorzugt werden die vereinzelten verkapselten Bauelemente mit Plasma und/oder Gas behandelt. Hierdurch ist vorteilhaft eine verbesserte Dichtigkeit erreichbar.

Die Erfindung betrifft insbesondere verkapselte Bauelemente mit einem gestapelten und mit Kleber gebondeten Aufbau, dessen Außenkanten nahezu gleich sind, umfassend:
- Baueinheiten,
- eine Rahmenstruktur, die die Baueinheiten umschließt und die innerhalb eines gestapelten Aufbaus einen geschlossenen Hohlraum ausbildet, und
- eine diffusionsdichte Abdeckung,

wobei die Rahmenstruktur als Abstandhalter zwischen den Baueinheiten und der Abdeckung fungiert,
wobei die Hermetizität nach der Vereinzelung der verkapselten Bauelemente durch Behandlung der Rahmenstruktur bzw. durch Behandlung des bereits gehärteten Klebers durch Plasma, bevorzugt O₂-Plasma und/oder UV/Ozon und/oder Laser und/oder reaktive Gase erreicht wird, wobei die Nachbehandlung ausschließlich mit Laser nicht unter den beanspruchten Gegenstand fällt.

Die erfindungsgemäßen Bauelemente erreichen insbesondere vorteilhaft eine verbesserte hermetische Verkapselung im Vergleich zum Stand der Technik, da die Nachbehandlung der äußeren Wände aus dem Rahmenmaterial zu einer Verdichtung der Oberfläche und somit einer hermetischen Verkapselung mit erhöhter Langzeit-Zuverlässigkeit führt.

Die Erfindung beschreibt insbesondere ein Verfahren zur Herstellung von hermetisch verkapselten Bauelementen mit folgenden Schritten:
- Aufbringen einer Rahmenstruktur, die jeweils einzelne Baueinheiten auf einem Produktsubstrat, bevorzugt fertig kontaktierte Baueinheiten je nach Baueinheit-Art, umschließt,
- Bonden von Produktsubstrat und Deckelsubstrat durch Verkleben der Rahmenstruktur mit dem diffusionsdichten Deckelsubstrat,
- Aushärtung des Klebers der Rahmenstruktur,
- Vereinzelung der verkapselten Bauelemente,
- Behandlung der bereits vereinzelten und verkapselten Bauelemente mit Plasma, bevorzugt C₂-Plasma und/oder UV/Ozon und/oder Laser und/oder reaktive Gase, wobei durch die Behandlung der Kleber-Rahmenstruktur eine Oberflächenumwandlung zu dichtem SiO₂ erreicht wird, wobei die Nachbehandlung ausschließlich mit Laser nicht unter den beanspruchten Gegenstand fällt.

Die Aushärtung der Rahmenstruktur kann in einer besonderen Ausführungsform auch vor dem Verbinden von Produktsubstrat und Deckelsubstrat erfolgen bzw. die Aushärtung der Rahmenstruktur erfolgt bevorzugt vor dem Bonden des Deckelsubstrats auf die Rahmenstruktur. In dieser Ausführungsform wird vor dem Verbinden von Produktsubstrat und Deckelsubstrat eine Schicht Kleber deckungsgleich auf der bereits gehärteten Rahmenstruktur aufgebracht und nach dem Verbinden ausgehärtet. Die Wahl der Ausführungsform richtet sich u.a. auch nach der notwendigen Höhe der Rahmenstruktur. Um die erforderliche Höhe der Rahmenstruktur zu erreichen, ist auch ein wiederholtes Auftragen von Material für die Rahmenstruktur denkbar, wobei jede Schicht je nach Materialauswahl entweder nicht ausgehärtet, teilweise ausgehärtet oder gänzlich ausgehärtet wird, bevor die nächste Schicht aufgetragen wird.

Ein Kern der Erfindung besteht insbesondere darin, dass durch die nachträgliche chemische und/oder physikalische Behandlung der Rahmenstruktur der bereits vereinzelten und verkapselten Bauelemente ein vereinfachtes Verfahren zum Verkapseln auf Waferebene mit Kleber angewendet werden kann, das eine Verkapselung hoher Qualität und Hermetizität ermöglicht.

Die Rahmenstruktur dient daher nicht nur als mechanischer Stabilisator, sondern auch als Schutz für in der Atmosphäre und/oder in der Umgebung vorkommende Partikel und Medien, insbesondere Fluide, noch spezifischer Flüssigkeiten oder Gase, insbesondere Wasser (Feuchtigkeit) und Sauerstoff.

Der Kleber der Rahmenstruktur kann beispielsweise durch Verfahren wie Inkjetverfahren, Druckverfahren, Gießen, Beschichten, Sprühen, Extrudieren und/oder Belacken aufgebracht werden. Eine weitere Technik zum Aufbringen des Klebers ist beispielsweise das Sprühbeschichten oder Sprühbelacken. Dabei handelt es sich um eine Technik, bei der eine Düse eine aufzutragende Flüssigkeit zerstäubt, während sie eine relative Bewegung zu einem Substrat durchführt. Bei der Relativbewegung zwischen Düse und Substrate kann es sich um eine einfache Rotation, eine Translation oder kompliziertere Bewegungen handeln.

Einige Klebermaterialien besitzen eine hohe Viskosität und müssen bei Bedarf mit einem Lösungsmittel verdünnt werden. Das Auftragen einer erfindungsgemäßen Rahmenstruktur am Produktsubstrat kann z.B. mit einer Anlage gemäß WO 2016/1 13008A1 erfolgen, auf die insofern verwiesen wird.

Alternativ können Inkjetverfahren sowie Druckverfahren, beispielsweise Mikrokontakt-Druckverfahren, Siebdruck oder Flexodruck, zum Auftragen der Kleber- bzw. der Rahmenstruktur eingesetzt werden.

Das erfindungsgemäße Verfahren geht von einer zweiteiligen Verkapselung aus, nämlich mit einer am Produktsubstrat die Baueinheiten umschließenden Rahmenstruktur und einem darauf aufsitzenden Deckelsubstrat. Vor der Verbindung für die Verkapselung müssen Produktsubstrat und Deckelsubstrat möglichst genau zueinander ausgerichtet werden. Die Ausrichtung der Substrate wird vorzugsweise mit entsprechenden Ausrichtungsvorrichtungen durchgeführt. Solche Ausrichtungsvorrichtungen werden beispielsweise in WO 2014/202106A1 beschrieben, auf die insofern verwiesen wird. Die Ausrichtung erfolgt vorzugsweise mittels Ausrichtungsmarken. Am Produktsubstrat befinden sich neben den Ausrichtungsmarken die funktionalen Einheiten, d.h. die Baueinheiten.

Bevorzugt weisen die Substrate annähernd identische Durchmesser auf, die insbesondere um weniger als 5 mm, vorzugsweise weniger als 3 mm, noch bevorzugter weniger als 1 mm, voneinander abweichen.

Anlagen zum Bonden von Substraten werden beispielsweise in den Patentschriften EP1564804B1 und US6,214,692B1 beschrieben. Das Ausrichten und Bonden erfolgt insbesondere gemäß den angegebenen Patentschriften und wird nicht näher beschrieben.

Die Vereinzelung kann durch verschiedene Verfahren durchgeführt werden. Als Trennverfahren in der Vereinzelung werden z.B. mechanisches Sägen sowie plasma- und/oder laserbasierte Trennverfahren eingesetzt.

Ein weiterer Gegenstand, der nicht Teil der beanspruchten Erfindung ist, aber hilfreich für deren Verständnis, betrifft insbesondere eine Anlage zur Herstellung und/oder Behandlung der vereinzelten und verkapselten Bauelemente, insbesondere zur Durchführung eines erfindungsgemäßen Verfahrens, aufweisend
- Eine Prozesskammer zur Aufnahme der vereinzelten und verkapselten Bauelemente,
- Eine Aufnahmeeinrichtung zur Aufnahme der vereinzelten und verkapselten Bauelemente,
- Eine Plasmaquelle und/oder eine UV-Licht und/oder eine Ozon-Quelle und/oder eine Laserquelle zur Behandlung der Rahmenstruktur der vereinzelten und verkapselten Bauelemente,
- Mittel zur Einleitung einer oder mehrerer gasförmigen Komponenten in die Prozesskammer,
- Heizmittel sowie Steuermittel zur Temperaturkontrolle von Aufnahmeeinrichtung und Prozesskammer.

Die Vorrichtung/Anlage kann modulartig ausgebildet und insbesondere Teil einer Gesamtanlage sein. Die Vorrichtung kann aber auch selbst eine Gesamtanlage mit mehreren Modulen sein.

Durch die Vorrichtung und das erfindungsgemäße Verfahren ist es insbesondere möglich, eine Vielzahl von vereinzelten und verkapselten Bauelementen gleichzeitig in der Vorrichtung zu laden, um dann gleichzeitig die äußeren Wände der Rahmenstrukturen zu behandeln, sodass zeitnah eine Oberflächenumwandlung zu dichtem SiOₓ, insbesondere SiOz, erreicht wird und somit die Langzeit-Hermetizität der Verkapselungen gewährleistet ist.

### Klebermaterial bzw. Material der Rahmenstruktur

Kleber, insbesondere UV-Kleber, werden zum Verbinden des Produktsubstrats mit dem Deckelsubstrat im erfindungsgemäßen Verfahren eingesetzt. Mit dem Kleber werden auch die Rahmenstrukturen um die einzelnen Baueinheiten am Produktsubstrat hergestellt. Die Rahmenstrukturen definieren nach der Vereinzelung die Außenwände der verkapselten Bauelemente.

Die Vereinzelung der verkapselten Bauelemente kann beispielsweise entweder mitten durch die Rahmenstrukturen oder zwischen zwei Rahmenstrukturen durchgeführt werden, je nachdem wie diese um die Baueinheiten eines Produktsubstrats aufgetragen worden sind.

Die Aushärtung des Klebers kann durch elektromagnetische Strahlung, durch Wärme, durch Strom, durch magnetische Felder und/oder andere Verfahren durchgeführt werden.

Die Aushärtung des Klebers erfolgt je nach Material bevorzugt durch elektromagnetische Strahlung, vorzugsweise durch UV-Licht oder IR-Licht. Die elektromagnetische Strahlung besitzt eine Wellenlänge im Bereich zwischen 10 nm und 2000 nm, mit Vorzug zwischen 10 nm und 1500 nm, mit größerem Vorzug zwischen 10 nm und 1000 nm, mit allergrößtem Vorzug zwischen 10 nm und 500 nm.

Denkbar sind auch thermische Aushärtungen. Die thermische Aushärtung erfolgt zwischen 0°C und 500°C, vorzugsweise zwischen 0°C und 400°C, noch bevorzugter zwischen 0°C und 300°C, am bevorzugtesten zwischen 0°C und 200°C.

Der Aushärtung liegt insbesondere eine Polymerisation des Klebers zu Grunde. Dabei wird die Polymerisation durch einen sogenannten Initiator gestartet. Wird elektromagnetische Strahlung für die Aushärtung verwendet, ist mindestens eines der beiden Substrate, insbesondere das Deckelsubstrat, transparent oder ausreichend transparent für elektromagnetische Strahlung des Wellenlängenbereichs, in dem es zu einer Vernetzung des Klebers kommt. Insbesondere ist das Deckelsubstrat ein Glas- oder ein Saphir-Substrat.

Zum Verkleben kann der Kleberauftrag ganzflächig oder selektiv entlang der Rahmenstruktur auf dem Produktsubstrat und/oder auf der Abdeckung (Deckelsubstrat) und/oder auf einer Zwischenschicht erfolgen. Wird die Rahmenstruktur mit dem Kleber aufgetragen, erfolgt der Kleberauftrag selektiv bzw. strukturiert zur Herstellung einer Rahmenstruktur bevorzugt am Produktsubstrat.

Bevorzugt werden Permanentkleber eingesetzt. Permanentkleber sind Polymere, deren Polymerketten unter chemischer, thermischer oder elektromagnetischer Einwirkung permanent miteinander vernetzen. Der Vernetzungsvorgang ist irreversibel. Derartige Polymere werden verwendet, um Substrate, insbesondere Substrate aus unterschiedlichen Materialien, miteinander zu verbinden.

Zu den Klebern gehören erfindungsgemäß u.a. Epoxidharze, Photoresist-Materialien, Fluoropolymere, Silsesquioxane, Benzocyclobutene, Polymethylmethacrylate, Polydimethylsiloxane (PDMS), Polyaryleneether, Polyetheretherketone, flüssigkristalline Polymere und thermoplastische Copolymere wie z.B. Polyvinylidenchlorid.

Für Wafer-to-Wafer (W2W) Verfahren haben sich Epoxy-Materialien wie SU-8 sowie Benzocyclobutene (BCB) als Kleber bei einer Bondtemperatur unter 250°C etabliert.

Bevorzugt werden Kleber auf Silikonbasis verwendet, wie beispielsweise Polydimethylsiloxan (PDMS) Kleber oder octafunktionelle polyhedrische Silsesquioxan (POSS) enthaltende Kleber, welche nach Härtung auf ihrer Oberfläche oder in den Oberflächen nahen Schichten Si-O und/oder Si-OH Einheiten aufweisen, die durch chemische und/oder physikalische Behandlung zu dichtem SiO₂ umgewandelt werden können. Insbesondere soll eine Oberflächenumwandlung stattfinden, wodurch eine Hermetisierung der Rahmenstruktur aus Kleber auf Silikonbasis erreicht wird.

In einer besonderen Ausführungsform kann das Rahmenstrukturmaterial bzw. der Kleber auch ein Polymerkomposit sein, um besondere Eigenschaften aufzuweisen. Der Kleber kann beispielsweise sowohl organische wie auch anorganische Anteile besitzen, oder Partikel, wie z.B. Metallpartikel, insbesondere Nanopartikel enthalten, oder elektrisch Leitfähig sein. Wird nur ein Teil der elektromagnetischen Strahlung vom ausgehärteten Kleber durchgelassen, wirkt die Rahmenstruktur bzw. der Kleber als Filter.

Beim Bonden werden Produktsubstrat und Deckelsubstrat verbunden. Das Bonden erfolgt durch Verkleben der Rahmenstruktur mit einem diffusionsdichten Deckelsubstrat, wobei beim Bonden auch Druck und/oder Temperatur eingesetzt werden können.

### Oberflächenumwandlung der Rahmenstruktur am vereinzelten und verkapselten Bauelement.

Einer der letzten Prozess-Schritte im Wafer-Level-Packaging ist das Vereinzeln, wobei die fertig prozessierten Substrate bzw. die fertigen und verkapselten Bauelemente getrennt werden. Das Vereinzeln der Bauelemente (engl.: dicing) kann mittels Sägen, Laser-Verfahren (Laser-Dicing) oder Plasma-Verfahren (Plasma-Dicing) stattfinden.

Erst nach dem Vereinzeln der verkapselten Bauelemente kann die Rahmenstruktur erfindungsgemäß nachbehandelt werden, sodass die gewünschte Hermetizität der Verkapselung erreicht wird. Die Behandlung der Rahmenstruktur der verkapselten Bauelemente nach der Vereinzelung hat den Vorteil, dass sie an mehreren vereinzelten und verkapselten Bauelementen gleichzeitig durchgeführt werden kann.

Nach der Vereinzelung müssen die verkapselten Bauelemente nicht zwingend frei liegen. Vor der Vereinzelung kann beispielsweise eine Sägefolie (engl.: dicing tape) am Substrat aufgeklebt werden. Sägefolien sind z.B. Klebefolien, thermische Folien oder UV-Folien. Das Substrat wird mit einem Sägerahmen fixiert. Sägeringe können die Folie zusätzlich im expandierten Zustand fixieren und werden zwischen Substrat und Sägerahmen eingedrückt.

In einer ersten beispielhaften Ausführungsform ist es für die Weiterbehandlung der verkapselten Bauelemente erforderlich, den Abstand der getrennten verkapselten Bauelemente durch expandieren der Sägefolie zu vergrößern. Dazu werden beispielsweise Expansionsrahmen eingesetzt. Das erlaubt einen verbesserten Zutritt zu den Seitenwänden i.e. zu der Rahmenstruktur der verkapselten Bauelemente und ermöglicht somit eine effizientere Nachbehandlung.

Sind die vereinzelten und verkapselten Bauelemente noch auf einer Folie fixiert, insbesondere auf einer in einem Sägerahmen eingespannten Sägefolie, können alle vereinzelten Bauelemente eines Substrats bzw. Wafers gleichzeitig auf Wafer-Level behandelt werden, ohne dass eine aufwendigere Einzelchip-Handhabung notwendig ist. Dabei können vorteilhaft die für die Handhabung von Wafer bereits vorhandene Vorrichtungen genützt werden wodurch sich die Nachbehandlungs-Prozesse vereinfachen.

Bevorzugt wird die Kompatibilität der Folien- und Rahmen-Materialien mit den (Nach)-Behandlungsmethoden wie beispielsweise, insbesondere, Plasma-Verfahren Fallweise überprüft und die entsprechend geeigneten Materialien werden selektiert.

Bei Prozessbedingungen, bei denen Folien nicht mehr geeignet sind, z.B. zu hohe Temperaturen und/oder chemische und/oder physikalische Ätzraten, werden in einer zweiten beispielhaften Ausführungsform die verkapselten Bauelemente in Einzelchip-Handhabungs-Verfahren bearbeitet. Somit können auch in dieser Ausführungsform mehrere vereinzelte und verkapselte Bauelemente gleichzeitig behandelt werden.

In einer dritten beispielhaften Ausführungsform können die vereinzelten und verkapselten Bauelemente auch lose in einer dafür geeigneten Aufnahmeeinrichtung transportiert und behandelt werden.

Insbesondere werden erfindungsgemäß zur Herstellung der Rahmenstruktur Kleber auf Silikonbasis bevorzugt, wie beispielsweise PDMS-Kleber oder POSS-enthaltende Kleber, welche nach Härtung auf ihrer Oberfläche oder in den Oberflächennahen Schichten Si-O und/oder Si-OH Einheiten aufweisen, die durch chemische und/oder physikalische Prozesse während der Nachbehandlung zu einer SiOₓ beziehungsweise einer SiO₂ Oberflächenschicht umgewandelt werden können.

Plasmaprozesse und Ionensputterprozesse werden in der Halbleiterindustrie zur Reinigung und/oder zur Aktivierung von Oberflächen verwendet. Die zum Stand der Technik gehörenden Methoden der Oberflächenreinigung und/oder der Oberflächenaktivierung dienen im Allgemeinen zur Vorbehandlung der Substratoberfläche für einen folgenden Prozess. Aus wissenschaftlichen Publikationen (beispielsweise "Progress in Adhesion and Adhesives", Ed. K.L. Mittal, Scrivener Publishing and John Wiley & Sons, 2015) ist bekannt, dass durch Plasma-Behandlung die Oberfläche von Polydimethylsiloxan (PDMS) aktiviert werden kann, sodass ein permanentes Bonden mit einer zweiten PDMS-Oberfläche oder einer Glas-Oberfläche möglich wird. Durch die Os-Plasmabehandlung wird die Oberfläche oxidiert und es entstehen Silanol-Gruppen an der PDMS-Oberfläche. Werden zwei Plasmabehandelte Oberflächen kontaktiert, entstehen kovalente -O-Si-O- Verbindungen.

Erfindungsgemäß bevorzugt können die mittels Sauerstoff, Stickstoff, Edelgasen oder komplexeren organischen gasförmigen Verbindungen erzeugten Plasmen die Substratoberfläche sowohl durch Ionenbeschuss als auch durch Oberflächenreaktionen mittels im Plasma vorhandener Ionen und/oder Radikale modifizieren.

In einer bevorzugten Ausführungsform wird Sauerstoff-Plasma (O₂-Plasma) eingesetzt. Erfindungsgemäß werden die Prozessparameter der O₂-Plasmabehandlung so optimiert, dass eine Oberflächenumwandlung der freiliegenden Rahmenstruktur, die aus Kleber auf Silikonbasis besteht, zu dichtem SiO₂ erfolgt. Dafür werden Prozessparameter wie Gasgemisch, Temperatur und Dauer der O₂-Plasmabehandlung so optimiert, dass eine erfolgreiche und dauerhafte Oberflächenumwandlung zu dichtem SiO₂ erfolgt. Dadurch wird eine hermetische Versiegelung der bereits ausgehärteten äußeren Rahmenstruktur der verkapselten Bauelemente erreicht.

In einer weiteren erfindungsgemäßen Ausführungsform wird eine zusätzliche Komponente im O₂-Plasma Prozess eingeführt, um durch Reaktion mit der Oberfläche der Rahmenstruktur eine schnellere Oberflächenumwandlung der freiliegenden Rahmenstruktur zu dichtem SiO₂ bzw. SiOₓ zu erreichen. Erfindungsgemäß bevorzugt kann die zusätzliche Komponente ein Gemisch mehrerer Substanzen sein oder eine einzelne chemische Verbindung. Bevorzugt wird die zusätzliche Komponente als Gas eingeleitet. In einer eigenständigen erfindungsgemäßen Ausführungsform werden Siloxane als chemische Verbindung eingesetzt. Dazu gehören z.B. Disiloxan, Hexamethyldisiloxan (HMDS) und Octamethyltrisiloxan. HMDS ist geeignet, stabile, kratzfeste Schichten sowie Schutzschichten im Plasma abzuscheiden. Dabei werden Plasmen mit HMDS-Sauerstoff-Gasgemische verwendet. Im Plasma entstehen hochreaktive Fragmente der Siloxan-Monomere (u.a. Radikale und Ionen) die eine Polymerschicht an der Oberfläche bilden (Plasmapolymerisation). Mit steigender Sauerstoffkonzentration entsteht die Schichtabscheidung durch Rekombination des Si-O-Si Radikals und die Schicht wird Quarzähnlich. Die Dicke der SiOₓ-Schicht kann durch die Dauer der Behandlung und die Konzentration der Siloxane gesteuert werden. Die Behandlung wird nur so lange fortgesetzt, bis die Rahmenstruktur der Verkapselung durch Bildung der SiOx-Oberflächenschicht die gewünschte Hermetizität im Sinne von Diffusions-Dichtheit erreicht.

In einer weiteren bevorzugten Ausführungsform wird die Rahmenstruktur nach der Vereinzelung der Bauelemente einer UV-Licht/Ozon (O₃) Behandlung unterzogen. Mittels einer kurzwelligen UV-Licht Behandlung können Oberflächen gereinigt und/oder modifiziert werden. Trifft UV-Strahlung mit einer Wellenlänge unter 200 nm auf Sauerstoff, wird Ozon gebildet. Das Ozon wird selbst durch UV-Licht unter Bildung hochreaktiver, freier Sauerstoffradikale zersetzt.

Insbesondere werden zur Herstellung der Rahmenstruktur Kleber auf Silikonbasis verwendet, wie beispielsweise PDMS-Kleber oder POSS-enthaltende Kleber, welche nach Härtung auf ihrer Oberfläche oder in den Oberflächen nahen Schichten Si-O und/oder Si-OH Einheiten aufweisen, die durch photochemische Prozesse während der UV/Ozon Behandlung zu einer SiOₓ Oberflächenschicht umgewandelt werden können. Diese photochemischen Prozesse finden bevorzugt bei Raumtemperatur statt.

Die Prozessparameter werden so optimiert, dass eine dünne SiOₓ Oberflächenschicht entstehen kann. In einer weiteren Ausführungsform kann analog der Plasmabehandlung auch in diesem Prozess eine zusätzliche Komponente eingeführt werden.

In einer weiteren Ausführungsform, die nicht unter den beanspruchten Gegenstand fällt, aber hilfreich für dessen Verständnis ist, wird die Rahmenstruktur nach der Vereinzelung der Bauelemente mit einer Strahlungsquelle, insbesondere einem Laser, behandelt. Erfindungsgemäß wird die Rahmenstruktur aus einem Kleber, bevorzugt ein Polymer-Kleber hergestellt. Bei einer Laserbestrahlung einer Polymermatrix finden sowohl thermische als auch athermische Wechselwirkungsvorgänge statt, die bis zu einer photochemischen Zersetzung der bestrahlten Struktur führen können. Es sind komplexe photochemische und auch photothermische Reaktionen, wobei die Anteile der photochemischen und photothermischen Reaktionen durch die Auswahl von 1) Polymermaterial, 2) Laserwellenlänge, 3) Pulszeiten, usw. variieren und somit gesteuert werden können. Unter athermische Vorgänge ist zu verstehen, dass die thermischen Effekte zwar noch vorhanden aber vernachlässigt werden können.

Bei der Bestrahlung der Rahmenstruktur mit Laser können z.B. Polymer-Fragmente, Zersetzungsprodukte und gasförmige Produkte entstehen, ohne eine hohe Temperaturentwicklung. Es werden athermische Wechselwirkungsvorgänge bevorzugt, um eine Belastung oder Schädigung der Bauelemente und der Verkapselung zu vermeiden.

Mit einer niedrigen Fluenz (Strahlungsenergie pro Fläche bei konstanter Pulsdauer) unterhalb der Abtragsgrenze können Änderungen in der chemischen Zusammensetzung der Polymeroberfläche erreicht werden. Die Intensität, mit der ein Polymer ohne Abtrag bestrahlt werden kann ist materialabhängig und wird experimentell ermittelt.

Die verkapselten und vereinzelten Bauelemente, insbesondere die Rahmenstrukturen, werden gemäß einer Ausführungsform, die nicht Teil der vorliegenden Erfindung ist, mit einer vorgegebenen Wellenlänge und/oder

Leistung und/oder Pulsdauer beaufschlagt, wobei die vorgegebenen Prozessparameter bevorzugt an das jeweilige Material angepasst sind. Diese Ausführungsform ist vorteilhaft, da die Eindringtiefe und die Prozesse durch die Wellenlänge und/oder die Pulszeiten und/oder die Laser-Leistung beeinflussbar sind.

Erfindungsgemäß werden Material der Rahmenstruktur bzw. Klebermaterial und Nachbehandlungsprozess derart miteinander abgestimmt, dass die gewünschte Material-Umwandlung zu dichtem SiOₓ optimiert stattfindet.

Ein wesentlicher Vorteil der Erfindung besteht insbesondere darin, dass die Hermetizität und somit die Qualität und Lebensdauer der mit Kleber als Verbindungsschicht im W2W Prozess hergestellten und verkapselten Bauelemente erhöht werden.

### Substrate

Unter einem Substrat bzw. Halbleitersubstrat wird ein noch nicht vereinzeltes, insbesondere rundes, Halbzeug der Halbleiterindustrie verstanden. Insbesondere beziehen sich die erfindungsgemäßen Ausführungsformen auf Wafer. Produktsubstrat und Deckelsubstrat sind mit Vorzug radialsymmetrisch. Obwohl das Substrat jeden beliebigen Durchmesser besitzen kann, ist der Substrat Durchmesser insbesondere 1 Zoll, 2 Zoll, 3 Zoll, 4 Zoll, 5 Zoll, 6 Zoll, 8 Zoll, 12 Zoll, 18 Zoll oder größer als 18 Zoll. In besonderen Ausführungsformen kann ein Substrat auch eine rechteckige, oder zumindest von der kreisförmigen Gestalt abweichende Form besitzen. Unter einem Substrat wird im weiteren Verlauf insbesondere ein Wafer verstanden. Bevorzugt weisen die Substrate annähernd identische Durchmesser D1 und D2 auf, die insbesondere um weniger als 5 mm, vorzugsweise weniger als 3 mm, noch bevorzugter weniger als 1 mm, voneinander abweichen.

### Deckelsubstrate

Um die Baueinheiten, die verpackt werden sollen, wird erfindungsgemäß eine Rahmenstruktur aus Kleber aufgetragen. Der Rahmen ist gleich hoch oder höher als die Baueinheiten und wird mit einem diffusionsdichten Deckel verschlossen. Als Material für das Deckelsubstrat eignen sich bevorzugt Glass, Silizium, oder Kunststoffe. Weitere Materialien sind beispielsweise Saphir-Glas, Halbleiter, Verbindungshalbleiter, Oxide, Keramik oder Metall. Der diffusionsdichte Substratdeckel kann transparent oder intransparent sein, wenn die Bauelemente von licht geschützt werden müssen. LEDs sind z.B. aus mehreren Schichten aufgebaut und meist durch eine Glas- oder Kunststoffplatte versiegelt. Die Qualität der Verkapselung bestimmt hier wesentlich die Lebensdauer da Sauerstoff, Feuchtigkeit oder Staubkörner zu einem Ausfall führen könnten.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
Figur 1a: eine Aufsicht auf ein Produktsubstrat mit Baueinheiten,
Figur 1b: eine Querschnittsansicht eines Produktsubstrats in einer ersten Ausführungsform,
Figur 1c: eine Querschnittsansicht eines Produktsubstrats in einer zweiten Ausführungsform,
Figur 2a: ein Produktsubstrat nach einem ersten Prozessschritt eines erfindungsgemäßen Verfahrens in einer ersten Ausführungsform,
Figur 2b: Seitenansicht des Produktsubstrats aus Figur 2a,
Figur 2c: Seitenansicht eines Produktsubstrats nach einem ersten Prozessschritt eines erfindungsgemäßen Verfahrens in einer zweiten Ausführungsform,
Figur 3a: Seitenansicht einer Rahmenstruktur eines Produktsubstrats in einer ersten Ausführungsform,
Figur 3b: Seitenansicht einer Rahmenstruktur eines Produktsubstrats in einer zweiten Ausführungsform,
Figur 3c: Seitenansicht einer Rahmenstruktur eines Produktsubstrats in einer dritten Ausführungsform,
Figur 4a: Seitenansicht eines verkapselten und vereinzelten Bauelements in einer ersten Ausführungsform,
Figur 4b: Seitenansicht eines verkapselten und vereinzelten Bauelements in einer ersten Ausführungsform nach einem Prozessschritt einer Nachbehandlung der Oberflächen zur Oberflächenumwandlung zu dichtem SiOₓ,
Figur 4c: eine Aufsicht auf ein erfindungsgemäßes vereinzeltes und verkapseltes Bauelement nach dem letzten Prozessschritt der Nachbehandlung der Oberflächen zur Oberflächenumwandlung zu dichtem SiOₓ,
Figur 5a: eine schematische Darstellung einer ersten Ausführungsform der erfindungsgemäßen Vorrichtung zur Nachbehandlung der verkapselten Bauelemente,
Figur 5b: eine schematische Darstellung einer zweiten Ausführungsform der erfindungsgemäßen Vorrichtung zur Nachbehandlung der verkapselten Bauelemente.

In den Figuren sind gleiche Bauteile oder Bauteile mit der gleichen Funktion mit den gleichen Bezugszeichen gekennzeichnet. Die Figuren sind nicht maßstabsgetreu dargestellt, um die Darstellung zu verbessern.

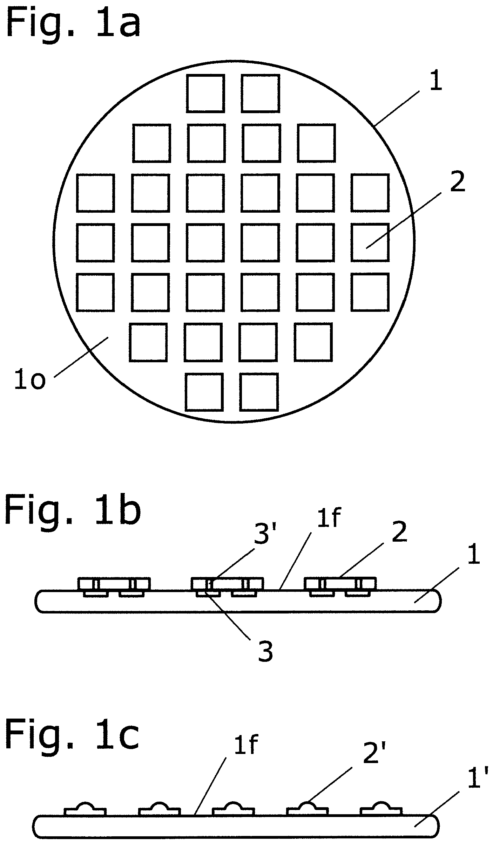

In Figur 1a ist ein Produktsubstrat 1 dargestellt, auf dessen Oberfläche 1o darauf befindliche Baueinheiten 2 hergestellt wurden. Gemäß Figur 1b können diese Baueinheiten 2 auch elektrisch leitende Verbindungen 3, 3' beinhalten.

In einer weiteren Ausführungsform gemäß Figur 1c sind die Baueinheiten 2' optische Strukturen, insbesondere Mikrolinsen, auf und/oder mit einem Trägersubstrat 1'. Die prozessierten Substrate 1, 1' weisen genau definierte Freiflächen 1f zwischen den Baueinheiten 2, 2' auf, um den Verkapselungsprozeß vollständig auf Waferebene durchführen zu können.

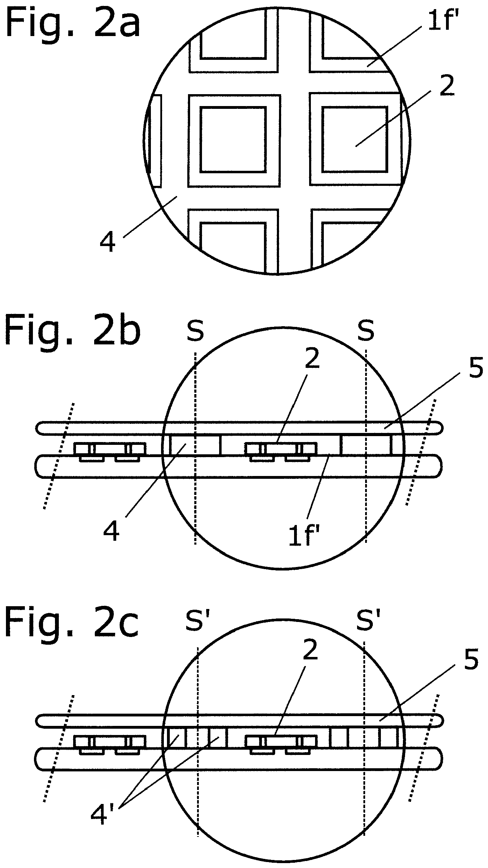

In einem ersten Schritt eines beispielhaften erfindungsgemäßen Verfahrens gemäß Figur 2a wird eine Rahmenstruktur 4 zwischen den Baueinheiten 2 aufgetragen.

Das erfindungsgemäße Verkapselungsverfahren geht von einer zweiteiligen Verkapselung aus, nämlich mit einer die Baueinheiten 2,2` umschließenden Rahmenstruktur 4 und einem darauf aufsitzenden Deckelsubstrat 5 gemäß Figuren 2b und 2c.

Die Rahmenstruktur 4 wird aus dem Kleber hergestellt, der für das Bonden zum Deckelsubstrat 5 eingesetzt wird.

In der Seitenansicht gemäß Figur 2b ist zu sehen, dass eine breite Rahmenstruktur 4 aufgetragen wurde. Es besteht ein Freiraum 1 f` zwischen den Baueinheiten 2 und der Rahmenstruktur 4. Die Vereinzelung der Bauelemente nach der Verkapselung gemäß Figur 2b findet beispielsweise entlang der Schnittlinien S statt.

In einem anderen Ausführungsbeispiel gemäß Figur 2c werden jeweils einzelne Rahmenstrukturen 4' zwischen die Baueinheiten 2 aufgetragen, sodass die Vereinzelung der Bauelemente nach der Verkapselung zwischen zwei Rahmenstrukturen 4` stattfindet. Siehe dazu die Schnittlinien S' aus Figur 2c.

Die Höhe der Rahmenstruktur 4 kann je nach Bedarf bzw. je nach Baueinheiten-Art 2, 2` stark variieren. Wird ein Hohlraum oberhalb der Baueinheiten 2,2' benötigt oder erwünscht, dann wird die benötigte Höhe der Rahmenstruktur 4 im Einzelfall optimiert.

Unter Höhe der Rahmenstruktur 4 ist die Gesamthöhe des Rahmens 4, 4', 4", 4‴ inklusive eventuell noch benötigter Kleberschichten zu verstehen.

Die Rahmenstruktur 4, 4', 4", 4‴ wird aus dem Klebermaterial hergestellt, der für das Bonden zum Deckelsubstrat 5 eingesetzt wird. Somit wird in der bevorzugten Ausführungsform nur ein Klebermaterial, zur Herstellung der Rahmenstruktur eingesetzt.

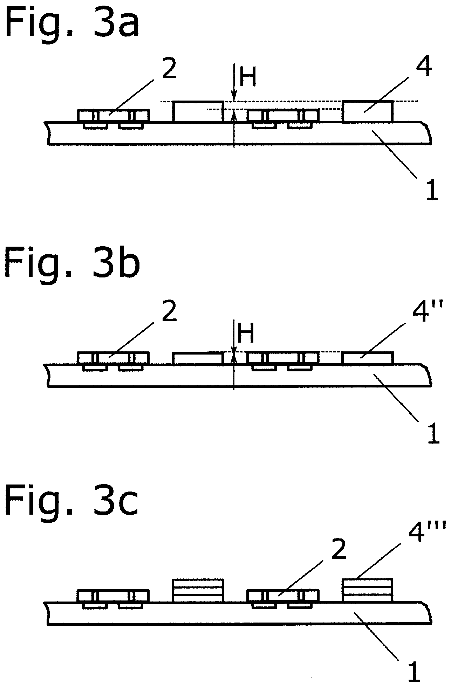

Nach dem Auftragen der Rahmenstruktur ergibt sich ein Höhenunterschied H zwischen den Baueinheiten 2,2' und der Rahmenstruktur 4, 4" gemäß Figuren 3a und 3b. In der Ausführungsform gemäß Figur 3b beträgt der Höhenunterschied H nahezu null, da die Rahmenstruktur 4" und die Baueinheiten 2 nahezu gleich hoch sind.

In einer anderen Ausführungsform gemäß Figur 3c kann die Rahmenstruktur 4‴ durch Auftragen mehrerer Schichten Material aufgebaut werden. Der Kleber als Material für die Rahmenstruktur 4‴ kann nach jeder aufgetragenen Schicht erfindungsgemäß partiell oder vollständig vernetzen i.e. Aushärten beispielsweise durch UV-Strahlung oder Wärmezufuhr. Je nach Viskosität und/oder Fließeigenschaften des Klebers können in einer alternativen ausführungsform zuerst mehrere Schichten übereinander aufgetragen werden bevor eine vollständige Aushärtung erfolgt.

Der Aushärtung liegt erfindungsgemäß bevorzugt eine Polymerisation des Klebers zu Grunde. Dabei wird die Polymerisation durch einen sogenannten Initiator gestartet. Wird elektromagnetische Strahlung für die Aushärtung verwendet, ist mindestens eines der beiden Substrate, insbesondere das Deckelsubstrat, transparent oder ausreichend transparent für elektromagnetische Strahlung des Wellenlängenbereichs, in dem es zu einer Vernetzung des Klebers kommt.

Die vollständige Aushärtung der Rahmenstruktur kann in einer besonderen Ausführungsform auch vor dem Verbinden von Produktsubstrat und Deckelsubstrat erfolgen. In dieser Ausführungsform wird vor dem Verbinden von Produktsubstrat und Deckelsubstrat eine Schicht Kleber deckungsgleich auf der bereits gehärteten Rahmenstruktur aufgebracht und nach dem Verbinden ausgehärtet.

Der Härtungsprozess erfolgt durch elektromagnetische Strahlung, insbesondere UV Licht und/oder durch Einwirkung von Wärmestrahlung. Die elektromagnetische Strahlung besitzt eine Wellenlänge im Bereich zwischen 10 nm und 2000 nm, mit Vorzug zwischen 10 nm und 1500 nm, mit größerem Vorzug zwischen 10 nm und 1000 nm, mit allergrößtem Vorzug zwischen 10 nm und 500 nm.

Eine Wärmebehandlung findet bei weniger als 750°C, vorzugsweise bei weniger als 500°C, noch bevorzugter bei weniger als 250°C, am bevorzugtesten bei weniger als 100°C, am allerbevorzugtesten bei weniger als 50°C statt. Eine Wärmebehandlung erfolgt vorzugsweise über Wärmeleitung durch den Probenhalter. Denkbar ist allerdings auch eine Erwärmung der umgebenden Atmosphäre oder eine Kombination daraus.

In einem zweiten Prozessschritt erfolgt das Verbonden von Produktsubstrat und Deckelsubstrat durch Verkleben der Rahmenstruktur mit dem diffusionsdichten Deckelsubstrat gemäß Figuren 2b und 2c, wobei der Kleber die Rahmenstruktur bildet. Beim Bonden von Produktsubstrat und Deckelsubstrat mit dem Kleber kann zusätzlich Druck und/oder Temperatur eingesetzt werden. Bei einem transparenten Deckelsubstrat kann die Aushärtung der Rahmenstruktur/des Klebers nach dem Verbinden von Produktsubstrat und Deckelsubstrat stattfinden.

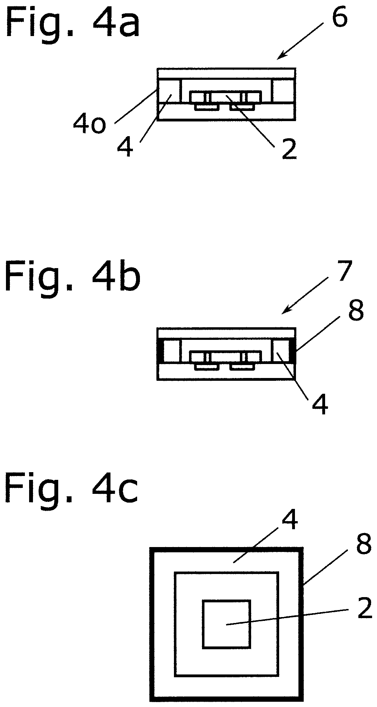

In einem weiteren Prozessschritt findet die Vereinzelung der verkapselten Bauelemente statt. Figur 4a zeigt ein vereinzeltes und verkapseltes Bauelement 6. Die Baueinheit 2 wird von der Rahmenstruktur 4 seitlich umrahmt. Beim Vereinzeln werden die am fertig prozessierten Substrat sich befindenden fertigen und verkapselten Bauelemente getrennt. Das Vereinzeln der Bauelemente kann mittels Sägen, Laser-Verfahren (Laser-Dicing) oder Plasma-Verfahren (Plasma-Dicing) stattfinden.

Die äußere Oberfläche der Rahmenstruktur 4o ermöglicht noch keine Verkapselung hoher Qualität und Hermetizität. Um eine Langzeitstabilität der Bauelemente zu ermöglichen, werden die vereinzelten und verkapselten Bauelemente in einem letzten Prozessschritt nachträglich behandelt. Insbesondere wird eine chemische Umwandlung der äußeren Oberfläche 4o der Rahmenstruktur 4 erreicht. Durch die erfindungsgemäße nachträgliche chemische und/oder physikalische Behandlung der Oberfläche der Rahmenstruktur 4o der bereits vereinzelten und verkapselten Bauelemente, wird ein vereinfachtes Verfahren zum Verkapseln auf Waferebene angewendet, das eine Verkapselung hoher Qualität und Hermetizität ermöglicht.

Die behandelte Rahmenstruktur dient daher nicht nur als mechanischer Stabilisator, sondern auch als Schutz für in der Atmosphäre und/oder in der Umgebung vorkommende Partikel und Medien, insbesondere Fluide, noch spezifischer Flüssigkeiten oder Gase, insbesondere Wasser (Feuchtigkeit) und Sauerstoff.

Die Figuren 4b und 4c zeigen jeweils in einer Seitenansicht und in einer Aufsicht die durch die erfindungsgemäße Nachbehandlung der verkapselten Bauelemente veränderte äußere Rahmenstruktur 8. Insbesondere werden erfindungsgemäß zur Herstellung der Rahmenstruktur Kleber auf Silikonbasis bevorzugt, wie beispielsweise PDMS-Kleber oder POSS-enthaltende Kleber, welche nach Härtung auf ihrer Oberfläche oder in den Oberflächen-nahen Schichten Si-O und/oder Si-OH Einheiten aufweisen, die durch chemische und/oder physikalische Prozesse während der Nachbehandlung zu einer SiOₓ Oberflächenschicht bzw. einer SiO₂-Schicht umgewandelt werden können.

Die äußere Schicht der Rahmenstruktur wird erfindungsgemäß Quarzähnlich. Die Dicke der SiOₓ-Schicht kann durch die Dauer der Behandlung gesteuert werden. Die Behandlung wird nur so lange fortgesetzt, bis die Rahmenstruktur der Verkapselung durch Bildung der SiOx-Oberflächenschicht die gewünschte Hermetizität im Sinne von Diffusions-Dichtheit erreicht. Die Bildung der SiOx-Oberflächenschicht bzw. SiO₂-Schicht auf der äußeren Rahmenstruktur ermöglicht eine hermetische Verkapselung trotz unterschiedlicher Materialien der Rahmenstruktur und der Substrate.

In einem letzten Prozessschritt findet die Nachbehandlung der verkapselten Bauelemente statt.

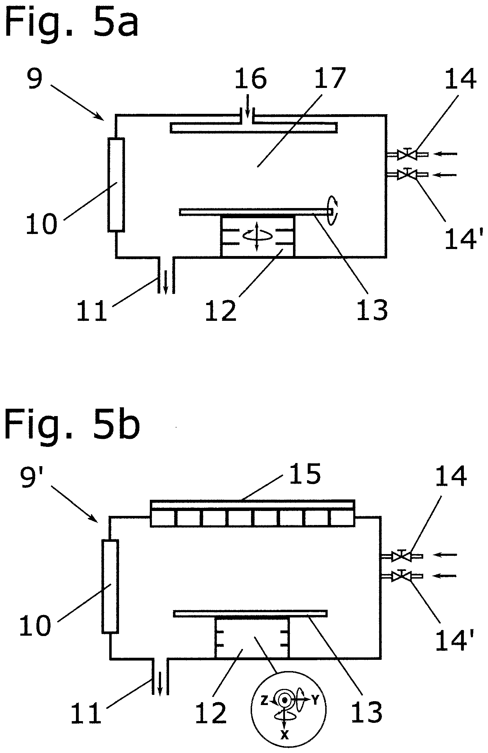

Figur 5a zeigt eine Prozesskammer zur Durchführung der Nachbehandlung der verkapselten Bauelemente gemäß einer ersten Ausführungsform. Nach der Vereinzelung müssen die verkapselten Bauelemente nicht zwingend frei liegen.

Sind die vereinzelten und verkapselten Bauelemente noch auf einer Folie fixiert, insbesondere auf einer in einem Sägerahmen eingespannten Sägefolie, können alle vereinzelten Bauelemente eines Substrats bzw. Wafers gleichzeitig auf Wafer-Level behandelt werden, ohne dass eine aufwendigere Einzelchip-Handhabung notwendig ist. Dabei können vorteilhaft die für die Handhabung von Wafer bereits vorhandene Vorrichtungen genützt werden, wodurch sich die Nachbehandlungs-Prozesse in einer Prozesskammer 9, 9` vereinfachen.

In einer ersten Ausführungsform ist es für die Weiterbehandlung der verkapselten Bauelemente erforderlich, den Abstand der getrennten Bauelemente durch expandieren der Sägefolie zu vergrößern. Dazu werden beispielsweise Expansionsrahmen eingesetzt. Das erlaubt einen verbesserten Zutritt zu den Seitenwänden i.e. zu der Rahmenstruktur der verkapselten Bauelemente und ermöglicht somit eine effizientere Nachbehandlung.

Bei Prozessbedingungen, bei denen Folien nicht mehr geeignet sind, z.B. hohe Temperaturen und/oder chemische und/oder physikalische Ätzraten, werden in einer zweiten Ausführungsform die verkapselten Bauelemente in Einzelchip-Handhabungs-Verfahren bearbeitet. Vorrichtungen und Verfahren zum Platzieren einer Lage von vereinzelten und verkapselten Bauelemente in definierten Positionen auf einem Substrat sind im Stand der Technik bekannt.

Somit können erfindungsgemäß auch in dieser Ausführungsform mehrere vereinzelte und verkapselte Bauelemente gleichzeitig behandelt werden.

In einer dritten Ausführungsform können die vereinzelten und verkapselten Bauelemente auch lose in einer geeigneten Aufnahmeeinrichtung transportiert und behandelt werden.

Gemäß Figuren 5a und 5b findet die Beladung der Prozesskammer 9, 9` mit den sich beispielsweise auf einer expandierten Sägefolie befindenden und ausgesägten verkapselten Bauelementstrukturen über eine Beladevorrichtung, bevorzugt eine Schleuse 10 statt. Eine Aufnahmevorrichtung 13 dient zur Fixierung des Sägerahmens bzw. des Substrats in der Prozesskammer 9, 9`. Der Tisch 12 ist insbesondere so konstruiert, dass bei der Beladung mit dem Sägerahmen oder Substrat dieser nach oben gefahren werden kann und ein Roboterarm das Substrat ablegen kann. Allgemeiner wird der Tisch 12 in einer Z-Richtung je nach Bedarf bewegt. Weiter ist eine Rotation und/oder ein Kippen der Aufnahmevorrichtung 13 möglich. Ein raumfestes Koordinatensystem für die Tischbewegungen ist beispielsweise in Figur 5b dargestellt.

Die Prozesskammer 9, 9` kann bevorzugt evakuiert und beheizt werden. Das Heizen kann durch beheizte Aufnahmevorrichtung(en) 13 und/oder durch Strahlungsheizung mit entsprechenden Wärmequellen stattfinden (nicht dargestellt). Die Prozesskammer 9, 9` ist mit einem Absaugungs- und/oder Vakuumsystem 11 ausgestattet. Die Aufnahmevorrichtung gemäß Figuren 5a und 5b eignet sich für Sägerahmen oder Substrate. Alternativ ist auch ein Korb als Aufnahmevorrichtung möglich.

Die Aufnahmevorrichtung 13 und/oder die Prozesskammer 9, 9` können in einem Temperaturbereich zwischen 0°C und 1000°C, vorzugsweise zwischen 0°C und 500°C, noch bevorzugter zwischen 0°C und 400°C, am bevorzugtesten zwischen 0°C und 350°C beheizt und temperiert werden.

Die Aufnahmevorrichtung 13 kann insbesondere über Löcher verfügen. Diese Löcher können kleiner sein als die verkapselten Bauelemente.

Die Aufnahmevorrichtung 13 kann zusätzlich über Sensoren verfügen (nicht dargestellt), mit deren Hilfe physikalische und/oder chemische Eigenschaften vermessen werden können. Diese Sensoren können beispielweise Temperatursensoren sein.

Die Ausführungsform gemäß Figur 5a zeigt eine Prozesskammer 9, bevorzugt eine Plasmakammer. Zur Erzeugung von Plasmen gibt es unterschiedliche Methoden, die sich hinsichtlich der Art der Energie-Einkopplung deutlich unterscheiden. Durch Anlegen einer Gleichspannung kann eine DC-Entladung erzeugt werden. Kapazitiv gekoppelte MHz-Entladungen (CCP capacitively coupled plasma) werden für das Plasmaätzen und die Plasmabeschichtung eingesetzt. Ionenflüsse und Plasmadichte können getrennt voneinander über die Verwendung von mehreren Frequenzen gesteuert werden. Bei einer induktiv gekoppelten Entladung (ICP inductively coupled plasma) wird die Plasmadichte noch weiter erhöht, da das Plasma als Sekundärwicklung eines Transformators fungiert.

Die mittels Sauerstoff, Stickstoff, Edelgasen oder komplexeren organischen gasförmigen Verbindungen erzeugten Plasmen können die Substratoberfläche sowohl durch Ionenbeschuss als auch durch Oberflächenreaktionen mittels im Plasma vorhandener Ionen und/oder Radikale modifizieren. Bevorzugt werden Plasmaprozesse verwendet, die chemische Wechselwirkungen mit dem Rahmenmaterial ermöglichen.

Figur 5a zeigt eine erste Ausführungsform einer Plasmakammer 9 mit Zufuhr reaktiver Teilchen von einem Downstream-Plasmareaktor 16. Solche Reaktoren werden eingesetzt, um den physikalischen Anteil einer Plasmaätzung völlig auszuschalten. Ein Plasma, bevorzugt ein Sauerstoff-Plasma 17, herrscht im Innenraum der Prozesskammer 9. Erfindungsgemäß können zum Erzeugen von Plasmen einzelne Gase eingesetzt werden sowie Mischungen davon. In einer bevorzugten Ausführungsform wird Sauerstoff-Plasma (O₂-Plasma) eingesetzt.

Eine zweite Ausführungsform einer Plasmakammer beinhaltet beispielsweise einen Parallelplattenreaktor mit symmetrischen Elektroden (in den Figuren nicht dargestellt). In dieser Ausführungsform finden chemische und physikalische Wechselwirkungen mit (u.a.) dem Rahmenmaterial statt. Unabhängig vom Aufbau der Plasmakammer, werden die Prozessparameter der O₂-Plasmabehandlung so optimiert, dass eine Oberflächenumwandlung der freiliegenden Rahmenstruktur, die aus Kleber auf Silikonbasis besteht, zu dichtem SiO₂ erfolgt. Dafür werden Prozessparameter wie Gasgemisch, Temperatur und Dauer der O₂-Plasmabehandlung so optimiert, dass eine erfolgreiche und dauerhafte Oberflächenumwandlung zu dichtem SiO₂ erfolgt. Dadurch wird eine hermetische Versiegelung der bereits ausgehärteten äußeren Rahmenstruktur der verkapselten Bauelemente erreicht. Ein Kippen der Aufnahmeeinrichtung 13 ermöglicht bei Bedarf einen optimierten Plasma-Zugang zu den seitlichen Rahmenstrukturen der vereinzelten und verkapselten Bauelemente.

In einer dritten erfindungsgemäßen Ausführungsform einer Plasma-Nachbehandlung wird eine zusätzliche Komponente im Oz-Plasma Prozess eingeführt, um durch Reaktion mit der Oberfläche der Rahmenstruktur eine schnellere Oberflächenumwandlung der freiliegenden Rahmenstruktur zu dichtem SiO₂ bzw. SiOₓ zu erreichen. Dabei kann die zusätzliche Komponente ein Gemisch mehrerer Substanzen sein oder eine einzelne chemische Verbindung. Bevorzugt wird die zusätzliche Komponente als Gas eingeleitet.

In die Prozesskammer 9, 9` gemäß Figuren 5a und 5b können weitere bevorzugt gasförmige Komponenten mittels Ventile 14, 14' eingeleitet werden.

In einer erfindungsgemäßen Ausführungsform werden Siloxane als chemische Verbindung eingesetzt. Dazu gehören z.B. Disiloxan, Hexamethyldisiloxan (HMDS) und Octamethyltrisiloxan.

Figur 5b zeigt eine weitere Ausführungsform einer Prozesskammer 9` zur Nachbehandlung der vereinzelten und verkapselten Bauelemente.

In der Prozesskammer 9` gemäß Figur 5b werden die äußeren Oberflächen der Rahmenstrukturen nach der Vereinzelung einer UV-Licht/Ozon (Os) Behandlung unterzogen. Eine Aufnahmevorrichtung 13 dient zur Fixierung des Sägerahmens bzw. des Substrats in der Prozesskammer 9'. Der Tisch 12 ist insbesondere so konstruiert, dass bei der Beladung mit dem Sägerahmen oder Substrat dieser nach oben gefahren werden kann und ein Roboterarm das Substrat ablegen kann. Allgemeiner wird der Tisch 12 in einer Z-Richtung je nach Bedarf bewegt. Weiter ist eine Rotation oder ein Kippen der Aufnahmevorrichtung 13 möglich. Ein raumfestes Koordinatensystem für die Tischbewegungen ist in Figur 5b dargestellt.

Sauerstoff wird mittels eines der Ventile 14, 14' in die Prozesskammer eingeführt. Strahlungsquellen 15 ermöglichen das Bestrahlen der verkapselten Bauelemente mit UV-Licht. Trifft UV-Strahlung mit einer Wellenlänge unter 200 nm auf Sauerstoff, wird Ozon gebildet. Das Ozon wird selbst durch UV-Licht unter Bildung hochreaktiver, freier Sauerstoffradikale zersetzt. Insbesondere werden erfindungsgemäß zur Herstellung der Rahmenstruktur Kleber auf Silikonbasis bevorzugt, wie beispielsweise PDMS-Kleber oder POSS-enthaltende Kleber, welche nach Härtung auf ihrer Oberfläche oder in den Oberflächen nahen Schichten Si-O und/oder Si-OH Einheiten aufweisen, die durch photochemische Prozesse während der UV/Ozon Behandlung zu einer SiOₓ Oberflächenschicht umgewandelt werden können. Diese photochemischen Prozesse finden bevorzugt bei Raumtemperatur statt. Dabei werden Prozessparameter so optimiert, dass eine dünne SiOₓ Oberflächenschicht entstehen kann. In einer weiteren Ausführungsform kann analog der Plasmabehandlung auch in diesem Prozess eine zusätzliche gasförmige Komponente über Ventile 14, 14' eingeführt werden. Analog der Prozesskammer aus Figur 5a sind auch hier eine Absaugung und/oder ein Vakuumsystem 11 sowie eine Schleuse 10 vorhanden.

### Strahlungsquelle(n) 15 können in alternativen Ausführungsformen der

Prozesskammer 9` auch IR-Licht und/oder Laser sein, wobei die Nachbehandlung nur mit IR-Licht und/oder Laser nicht Teil der beanspruchten Erfindung ist.

Die Strahlungsquelle 15 kann je nach Bedarf aus mehreren (parallelen) Lichtquellen bestehen sowie aus nur einer einzigen Strahlungsquelle. Diese Strahlungsquelle kann beweglich ausgeführt sein. Insbesondere wird in einer weiteren Ausführungsform die Rahmenstruktur nach der Vereinzelung der Bauelemente mit einem Laser behandelt.

Bevorzugt werden zumindest überwiegend, vorzugsweise ausschließlich, kohärente Photonenquellen, insbesondere Mikrowellenquellen, vorzugsweise Maser, oder als kohärente Photonenquellen für sichtbares, IR-, UV- und Röntgenlicht ausgebildete Laser verwendet. Mit einer niedrigen Fluenz (Strahlungsenergie pro Fläche bei konstanter Pulsdauer) unterhalb der Abtragsgrenze können damit Änderungen in der chemischen Zusammensetzung der Rahmenmaterialoberfläche erreicht werden.

Die verkapselten und vereinzelten Bauelemente, insbesondere die Rahmenstrukturen, werden mit einer vorgegebenen Wellenlänge und/oder Leistung und/oder Pulsdauer beaufschlagt, wobei die vorgegebenen Prozessparameter bevorzugt an das jeweilige Material angepasst sind. Diese Ausführungsform ist vorteilhaft, da die Eindringtiefe und die Prozesse durch die Wellenlänge und/oder die Pulszeiten und/oder die Laser-Leistung beeinflussbar sind. Die Photonenquellen können im Dauerbetrieb oder bevorzugt im Pulsbetrieb betrieben werden. Die Pulszeiten sind insbesondere kleiner als 1 s, vorzugsweise kleiner als 1 ms, noch bevorzugter kleiner als 1 µs, am bevorzugtesten kleiner als 1 ns. Die Zeiten zwischen zwei aufeinanderfolgenden Pulsen sind vorzugsweise größer als 1 ms, noch bevorzugter größer als 10 ms, am bevorzugtesten größer als 1 s. Ein Kippen der Aufnahmeeinrichtung 13 ermöglicht zusätzlich bei Bedarf einen optimierten Strahlungs-Zugang zu den (seitlichen) Rahmenstrukturen der vereinzelten und verkapselten Bauelemente.

In einer gesonderten Ausführungsform ist die Prozesskammer 9, 9` als Modul in einem Clustersystem angeordnet. Das Modul, in welchem sich die Prozesskammer zur Nachbehandlung der verkapselten Bauelemente befindet, kann, je nach Bedarf, mit Vorzug unabhängig vom (Vakuum-)Clustersystem, auf einen Druck von weniger als 1 bar, mit Vorzug weniger als 10⁻³ mbar, mit größerem Vorzug weniger als 10⁻⁵ mbar, mit größtem Vorzug weniger als 10⁻⁸ mbar evakuiert werden.

Nach dem Ausschleusen der prozessierten verkapselten Bauelemente aus der Prozesskammer können diese einzeln von der Sägefolie abgenommen werden. Insbesondere werden Material der Rahmenstruktur bzw. Klebermaterial und Nachbehandlungsprozess derart miteinander abgestimmt, dass die gewünschte Material-Umwandlung zu dichtem SiOₓ optimiert stattfindet. Ein wesentlicher Vorteil der Erfindung besteht insbesondere darin, dass durch die Nachbehandlung die Hermetizität und somit die Qualität und Lebensdauer der mit Kleber als Verbindungsschicht im W2W Prozess hergestellten und verkapselten Bauelemente erhöht werden.

### Bezugszeichenliste

- 1: Produktsubstrat/Trägersubstrat
- 1o: Substratoberfläche
- 1f, 1f': Freifläche
- 2, 2': Baueinheiten
- 3, 3': Kontakte und/oder elektrisch leitende Verbindungen
- 4, 4', 4", 4‴: Rahmenstruktur
- 4o: Außenfläche der Rahmenstruktur an den verkapselten und vereinzelten Bauelementstrukturen
- 5: Deckelung-Substrat/Deckelsubstrat
- S, S': Schnittlinie
- H: Höhenunterschied zwischen Aufbau Rahmenstruktur und Bauelementstruktur
- 6: Verkapseltes und vereinzeltes Bauelement
- 7: Verkapseltes und vereinzeltes Bauelement nach der Nachbehandlung der (Rahmenstruktur-)Oberflächen
- 8: SiOₓ-Oberflächenschicht
- 9, 9`: Prozesskammer
- 10: Schleuse
- 11: Absaugung und/oder Vakuumsystem
- 12: Tisch
- 13: Aufnahmevorrichtung für vereinzelte und verkapselte Bauelemente (Sägerahmen, Substrat, Korb, usw.)
- 14, 14`: Gasventil
- 15: Strahlungsquelle(n) (IR-Licht und/oder UV-Licht und/oder Laser, usw.)
- 16: Zufuhr reaktiver Teilchen von einem Downstream-Plasmareaktor
- 17: (O₂-)Plasma

## Patentansprüche

1. Verfahren zur Herstellung von vereinzelten verkapselten Bauelementen (6,7), mit den folgenden Schritten:
- Aufbringen einer Rahmenstruktur (4, 4', 4", 4‴) auf eine Substratoberfläche (1o) eines Substrats (1), wobei die Rahmenstruktur (4, 4', 4", 4‴) auf der Substratoberfläche (1o) angeordnete Baueinheiten (2,2') umschließt,
- Bonden eines Deckelsubstrats (5) auf die Rahmenstruktur (4, 4', 4", 4‴),
- Aushärtung der Rahmenstruktur (4, 4', 4", 4‴),
- Vereinzelung der verkapselten Bauelemente (6,7),
- wobei die Rahmenstruktur (4, 4', 4", 4‴) aus einem Kleber gebildet wird, **dadurch gekennzeichnet, dass** die vereinzelten verkapselten Bauelemente (6,7) mit Plasma und/oder reaktivem Gas behandelt werden, wobei die Plasma- und/oder Gasbehandlung nach der Aushärtung der Rahmenstruktur erfolgt, wobei durch die Plasma- und/oder Gasbehandlung eine chemische Umwandlung der äußeren Oberfläche der Rahmenstruktur (4, 4', 4", 4‴) erfolgt.

2. Verfahren nach Anspruch 1, wobei der Kleber ein Silikonkleber ist.

3. Verfahren nach einem der vorhergehenden Ansprüche, wobei die vereinzelten verkapselten Bauelemente (6,7) derart behandelt werden, dass auf der äußeren Oberfläche der Rahmenstruktur (4, 4', 4", 4‴) eine glasartige Struktur entsteht, insbesondere eine SiO2-Struktur.

4. Verfahren nach einem der vorhergehenden Ansprüche, wobei die Aushärtung der Rahmenstruktur (4, 4', 4", 4‴) vor dem Bonden des Deckelsubstrats (5) auf die Rahmenstruktur (4, 4', 4", 4‴) erfolgt.

5. Verfahren nach einem der vorhergehenden Ansprüche, wobei der Kleber der Rahmenstruktur (4, 4', 4", 4‴) durch Inkjetverfahren, Druckverfahren, Gießen, Beschichten, Sprühen, Extrudieren, Sprühbeschichten, Sprühbelacken und/oder Belacken aufgebracht wird.

6. Vereinzeltes verkapseltes Bauelement (6,7), hergestellt mit einem Verfahren gemäß einem der vorhergehenden Ansprüche.

## Claims

1. A method for the production of singulated encapsulated components (6, 7), with the following steps:
- application of a frame structure (4, 4', 4", 4‴) and a substrate surface (1o) of a substrate (1), wherein the frame structure (4, 4', 4", 4‴) surrounds components (2, 2') arranged on the substrate surface (1o),
- bonding of a cover substrate (5) and the frame structure (4, 4', 4", 4‴),
- curing of the frame structure (4, 4', 4", 4‴),
- singulation of the encapsulated components (6, 7),
wherein the frame structure (4, 4', 4", 4‴) is formed from an adhesive,
**characterised in that** the singulated encapsulated components (6, 7) are treated with plasma and/or reactive gas, wherein the plasma and/or gas treatment takes place after the curing of the frame structure, wherein a chemical conversion of the outer surface of the frame structure (4, 4', 4", 4‴) takes place as a result of the plasma and/or gas treatment.

2. The method according to claim 1, wherein the adhesive is a silicone adhesive.

3. The method according to any one of the preceding claims, wherein the singulated encapsulated components (6, 7) are treated in such a way that a vitreous structure, in particular an SiO2 structure, arises on the outer surface of the frame structure (4, 4', 4", 4‴).

4. The method according to any one of the preceding claims, wherein the curing of the frame (4, 4', 4", 4‴) takes place before the bonding of the cover substrate (5) on the frame structure (4, 4', 4", 4‴).

5. The method according to any one of the preceding claims, wherein the adhesive of the frame structure (4, 4', 4", 4‴) is applied by an injection process, a printing process, casting, coating, spraying, extruding, spray-coating, spray-lacquering and/or lacquering.

6. A singulated encapsulated component (6, 7), produced with a method according to any one of the preceding claims.

## Revendications

1. Procédé de fabrication d'éléments de construction isolés encapsulés (6, 7), comprenant les étapes suivantes :
- placement d'une structure-cadre (4, 4', 4", 4"') sur une surface de substrat (1o) d'un substrat (1), dans lequel la structure-cadre (4, 4', 4", 4"') entoure des unités de construction (2, 2') disposées sur la surface de substrat (1o),
- liaison d'un substrat de couverture (5) sur la structure-cadre (4, 4', 4", 4‴),
- durcissage par vieillissement de la structure-cadre (4, 4', 4", 4'"),
- isolement des éléments de construction encapsulés (6, 7),
dans lequel la structure-cadre (4, 4', 4", 4"') est formée d'un adhésif,
**caractérisé en ce que** les éléments de construction isolés encapsulés (6, 7) sont traités au plasma et/ou avec un gaz réactif, dans lequel le traitement au plasma et/ou au gaz est effectué après le durcissage par vieillissement de la structure-cadre, dans lequel du fait du traitement au plasma et/ou au gaz, il se produit une transformation chimique de la surface extérieure de la structure-cadre (4, 4', 4", 4'").

2. Procédé selon la revendication 1, dans lequel la colle est une colle silicone.

3. Procédé selon l'une des revendications précédentes, dans lequel les éléments de construction isolés encapsulés (6, 7) sont traités de façon à ce que sur la surface extérieure de la structure-cadre (4, 4', 4", 4"'), il se produise une structure vitreuse, en particulier une structure SiO2.

4. Procédé selon l'une des revendications précédentes, dans lequel le durcissage par vieillissement de la structure-cadre (4, 4', 4", 4‴) est effectué avant la liaison du substrat de couverture (5) sur la structure-cadre (4, 4', 4", 4‴).

5. Procédé selon l'une des revendications précédentes, dans lequel la colle de la structure-cadre (4, 4', 4", 4"') est appliquée par procédé par jet d'encre, procédé d'impression, coulage, revêtement, pulvérisation, extrusion, revêtement par pulvérisation, laquage par pulvérisation et/ou laquage.

6. Élément de construction individuel encapsulé (6, 7), fabriqué avec un procédé selon l'une des revendications précédentes.
